# EUROPEAN PATENT SPECIFICATION

(11) **EP 3 192 885 B1**
(45) Date of publication and mention of the grant of the patent: **06.05.2020**
(21) Application number: 17150775.9
(22) Date of filing: 10.01.2017
(51) Int. Cl.: C22C 19/05, C23C 28/00, C23C 30/00

(54) **INTERNALLY COOLED NI-BASE SUPERALLOY COMPONENT WITH SPALLATION-RESISTANT TBC SYSTEM**
INNENGEKÜHLTES BAUTEIL AUS EINER SUPERLEGIERUNG AUF NI-BASIS MIT SPALLATIONSBESTÄNDIGEM TBC-SYSTEM
COMPOSANT À REFROIDISSEMENT INTERNE, DE SUPERALLIAGE À BASE NI AVEC SYSTÈME TBC ANTI ÉCLATEMENT

(30) Priority: 12.01.2016 US 201614993140
(43) Date of publication of application: 19.07.2017
(73) Proprietor: United Technologies Corporation, Farmington, CT 06032 (US)
(72) Inventor: Task, Michael N., Vernon, CT 06066 (US); Boeke, Mark A., Plainville, CT 06062 (US); Levine, Jeffrey R., Vernon Rockville, CT 06066 (US); Bergman, Russell J., Windsor, CT 06095 (US)
(74) Representative: Dehns

(56) References cited:
- EP-A1- 2 145 969
- EP-A1- 2 208 805
- EP-A2- 1 528 124
- EP-A2- 1 837 412
- WO-A1-2011/019486

## Description

### BACKGROUND

The present disclosure particularly relates to a system of combining three technologies of an air cooled nozzle segment, a bond coat, and a thermal barrier coating, that results in a materials system that can be used in the hot section of a gas turbine engine, resulting in a substantial life extension an improved oxidation and fatigue resistant metallic coating for protecting high temperature gas turbine engine components.

Various metallic coatings have been developed in the past for the oxidation protection of high temperature gas turbine engine components. These coatings are often based on different aluminide compositions, and may include nickel or cobalt base metal materials. Alternatively, they are based on overlay deposits with MCrAlY foundations where M is nickel, cobalt, iron or combinations of these materials. These coating systems suffer from shortcomings that preclude their use on newer advanced turbine components. The diffused aluminides, while possessing good fatigue resistance, generally provide lower high temperature oxidation resistance (above 2000 degrees Fahrenheit). The overlay MCrAlY coatings tend to have tensile internal stress, which can promote cracking and reduces the fatigue life of the coating (i.e. creates fatigue debt). The addition of active elements to the MCrAlY coatings not only provides excellent oxidation resistance, but makes them good candidates for bond-coats for thermal barrier coatings.

Thermal barrier coating systems (TBCs) provide a means to protect the turbine engine components from the highest temperatures in the engine. Before a TBCs is applied, metallic bond coats, such as aluminides or MCrAlY coatings, are deposited on the surface of the turbine engine component, and a thermally grown oxide of alumina is grown between the bond coat and the TBCs topcoat.

As superalloy technology advances, the economics and material trade-offs involved in creating creep resistant higher refractory-containing super alloys have become of interest. While both aluminides and MCrAlY coatings have widespread applications, a low-cost improved coating that could combine the best properties from both would have immediate application on advanced turbine components where fatigue, pull weight, and oxidation must all be minimized.

### SUMMARY

In accordance with the present disclosure, there is provided a method for providing a component with a coating system comprising the steps of providing an air cooled component having a substrate; applying a metallic bondcoat to the substrate; and depositing a layer of an yttria-stabilized zirconia thermal barrier coating on the bondcoat. The air cooled component comprises a nozzle segment selected from the group consisting of a singlet, a doublet and a triplet. The metallic bond coat has a composition that consists of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.0 to 1.0 wt % zirconium, 0.0 to 10 wt % tantalum, 0.0 to 9.0 wt % tungsten, 0.0 to 10 wt % molybdenum, 0.0 to 43.0 wt % platinum, and the balance nickel.

In another and alternative embodiment, the metallic bondcoat applying step comprises applying a metallic bondcoat selected from the group consisting of a platinum-aluminide coating and an aluminide coating.

In another and alternative embodiment, the metallic bondcoat applying step comprises applying a metallic bondcoat wherein the metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 2.5-5.0 wt % tungsten, 0.0 to 10 wt % molybdenum, 23.0 to 27.0 wt % platinum, and the balance nickel.

In another and alternative embodiment, the yttria-stabilized zirconia coating depositing step comprises depositing a material containing from 4.0 to 25 wt % yttria.

In another and alternative embodiment, the air cooled component providing step comprises providing a substrate formed from a nickel based alloy.

In another and alternative embodiment, the yttria-stabilized zirconia coating depositing step comprises depositing a material consisting of from 4.0 to 25 wt % yttria and the balance zirconia.

In another and alternative embodiment, the method further comprises installing the air cooled component in a high pressure turbine section of a gas turbine engine.

In accordance with the present disclosure, there is provided a gas turbine engine obtained by the methods as herein described.

In accordance with the present disclosure, there is provided a gas turbine engine component comprises a nozzle segment, the nozzle segment comprising at least one substrate having a surface. A metallic bondcoat is coupled to the surface of the substrate. An yttria-stabilized zirconia thermal barrier coating is coupled to the metallic bondcoat opposite the surface. The nozzle segment is selected from the group consisting of a singlet, a doublet and a triplet. The metallic bond coat has a composition that consists of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.0 to 1.0 wt % zirconium, 0.0 to 10 wt % tantalum, 0.0 to 9.0 wt % tungsten, 0.0 to 10 wt % molybdenum, 0.0 to 43.0 wt % platinum, and the balance nickel.

In another and alternative embodiment, the metallic bondcoat is selected from the group consisting of a platinum-aluminide coating and an aluminide coating.

In another and alternative embodiment, the metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 2.5-5.0 wt % tungsten, 0.0 to 10 wt % molybdenum, 23.0 to 27.0 wt % platinum, and the balance nickel.

In another and alternative embodiment, the yttria-stabilized zirconia coating comprises a material containing from 4.0 to 25 wt % yttria.

In another and alternative embodiment, the yttria-stabilized zirconia coating comprises a material consisting of from 4.0 to 25 wt % yttria and the balance zirconia.

In another and alternative embodiment, the nozzle segment is configured air cooled.

Other details of the coating system and process are set forth in the following detailed description and the accompanying drawing wherein like reference numerals depict like elements.

### BRIEF DESCRIPTION OF THE DRAWINGS

FIG. 1 is a schematic representation of a turbine engine component;
Fig. 2. Is a chart of the weight gain per surface area of a first family of coatings 2 and a third family of coatings 4 as they compare to a Re-containing coating of U.S. Pat. No. 6,919,042 2 and the U.S. Pat. No. 6,919,042 Re-containing coating with platinum 3;
FIG. 3 is a schematic representation of a turbine engine component with the disclosed coating system.

### DETAILED DESCRIPTION

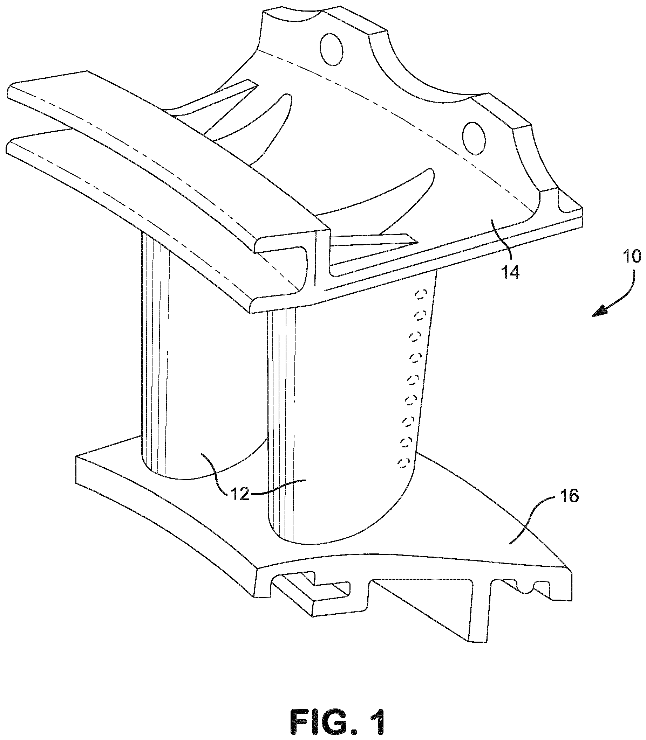

Referring to FIG. 1, a nozzle segment 10 that is one of a number of nozzle segments that when connected together form an annular-shaped nozzle assembly of a gas turbine engine. The segment 10 is made up of multiple vanes 12, each defining an airfoil and extending between outer and inner platforms (bands) 14 and 16. The vanes 12 and platforms 14 and 16 can be formed separately and then assembled, such as by brazing the ends of each vane 12 within openings defined in the platforms 14 and 16.

Alternatively, the entire segment 10 can be formed as an integral casting. When the nozzle segment 10 is assembled with other nozzle segments to form a nozzle assembly, the respective inner and outer platforms of the segments form continuous inner and outer bands between which the vanes 12 are circumferentially spaced and radially extend.

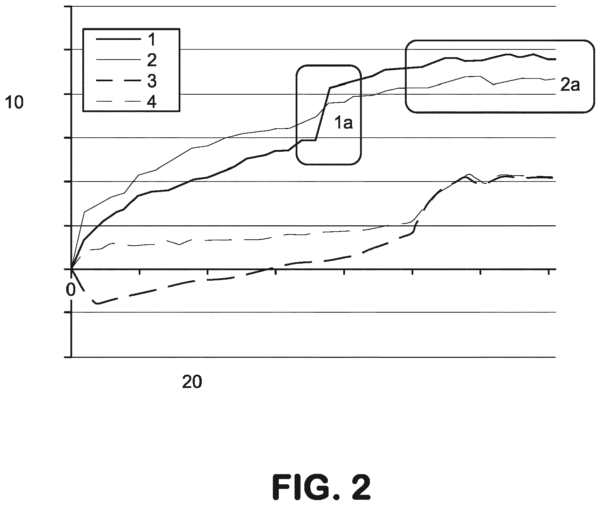

The nozzle segment 10 depicted in FIG. 2 is termed a doublet because two vanes 12 are associated with each segment 10. Nozzle segments can be equipped with more than two vanes, e.g., three (termed a triplet), or with a single vane to form what is termed a singlet.

The air-cooled nozzle segments of the high pressure turbine (HPT) stage 2 nozzle assembly of the gas turbine engine are cast from the nickel-base super alloy.

As a result of being located in the high pressure turbine section of the engine, the vanes 12 and the surfaces of the platforms 14 and 16 facing the vanes 12 are subjected to the hot combustion gases from the engine's combustor. As previously noted, in addition to forced air cooling techniques, the surfaces of the vanes 12 and platforms 14 and 16 are typically protected from oxidation and hot corrosion with an environmental coating, which may then serve as a bond coat to a TBC deposited on the surfaces of the vanes 12 and platforms 14 and 16 to reduce heat transfer to the segment 10.

Turbine engine components are formed from nickel-based, cobalt-based, and iron-based alloys. Due to the extreme high temperature environments in which these components are used, it is necessary to provide them with a protective coating. Metallic bond coatings must have a composition which minimizes the fatigue impact on the turbine engine components to which they are applied and at the same time provides maximum oxidation resistance properties. The coating must also be one where the thermal expansion mismatch between the coating and the alloy(s) used to form the turbine engine components is minimized. This mismatch is a cause of fatigue performance of MCrAlY coatings.

In accordance with the present disclosure, low-cost metallic coatings have been developed which reduce the thermal mismatch and which provide a good oxidation and fatigue resistance. The coatings can be used as stand-alone bond coat or as a bond coat used within a TBC system. These metallic coatings have a composition which broadly consists of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.0 to 1.0 wt % zirconium, 0.0 to 10 wt % tantalum, 0.0 to 9.0 wt % tungsten, 0.0 to 10 wt % molybdenum, 0.0 to 43.0 wt % platinum, and the balance nickel.

Within the foregoing broad scope of coating compositions, a first family of particularly useful coatings for turbine engine components has a composition which consists of 1.0 to 15 wt %, for example 10.0 wt % cobalt, 5.0 to 18 wt %, for example 5.0 wt % chromium, 5.0 to 12 wt %, for example 11.0 wt % aluminum, 0.01 to 1.0 wt %, for example 0.6 wt % yttrium, 0.01 to 0.6 wt %, for example 0.6 wt % hafnium, 0.0 to 0.3 wt %, for example 0.2 wt % silicon, 0.0 to 1.0 wt %, for example 0.1 wt % zirconium, 3.0 to 10 wt %, for example 3.0 to 6.0 wt % tantalum, 0.0 to 5.0 wt %, for example 2.5 to 5.0 wt % tungsten, 0.0 to 10 wt %, for example 2.0 wt % or less molybdenum, and the balance nickel. The total combined amount of tantalum and tungsten in these metallic coatings is in the range of 3.0 to 12 wt % and for example in the range of 5.5 to 11.0 wt %.

Within this first family of coatings, a particularly useful coating composition consists of 10.0 wt % cobalt, 5.0 wt % chromium, 11.0 wt % aluminum, 0.6 wt % yttrium, 0.6 wt % hafnium, 0.2 wt % silicon, 0.1 wt % zirconium, 3.0 to 6.0 wt % tantalum, 2.5 to 5.0 wt % tungsten, 0.8 to 1.7 wt % molybdenum, and the balance nickel.

For somewhat slower oxidation kinetics, a second family of particularly useful metallic coating compositions comprises 1.0 to 15 wt %, for instance 10.0 wt % cobalt, 5.0 to 18 wt %, for instance 5.0 wt % chromium, 5.0 to 12 wt %, for instance 11.0 wt % aluminum, 0.01 to 1.0 wt %, for example 0.6 wt % yttrium, 0.01 to 0.6 wt %, for example 0.6 wt % hafnium, 0.0 to 0.3 wt %, for example 0.2 wt % silicon, 0.0 to 1.0 wt %, for example 0.1 wt % zirconium, and the balance nickel. This second family of metallic coating may also contain 0.0 to 43.0% platinum and is devoid of all refractory metals, i.e. tungsten, molybdenum, tantalum, niobium and rhenium. These refractory elements are known to provide strength to superalloy materials; however, they are not known to possess oxidation resistant properties, they are expensive and at higher levels they promote topologically close packed phases.

Within this second family of coatings, a particularly useful coating composition consists of about 10.0 wt % cobalt, 5.0 wt % chromium, 11.0 wt % aluminum, 0.6 wt % yttrium, 0.6 wt % hafnium, 0.2 wt % silicon, 0.1 wt % zirconium, and the balance nickel.

A third family of particularly useful coatings for turbine engine components has a composition which consists of 1.0 to up to about 15 wt %, for example 10.0 wt % cobalt, 5.0 to 18 wt %, for example 5.0 wt % chromium, 5.0 to 12 wt %, for example 11.0 wt % aluminum, 0.01 to 1.0 wt %, for example 0.6 wt % yttrium, 0.01 to 0.6 wt %, for example 0.6 wt % hafnium, 0.0 to 0.3 wt %, for example 0.2 wt % silicon, 0.0 to 1.0 wt %, for example 0.1 wt % zirconium, 3.0 to 10 wt %, for example 3.0 to 6.0 wt % tantalum, 0.0 to 5.0 wt %, for example 2.5 to 5.0 wt % tungsten, 0.0 to 10 wt %, for example 2.0 wt % or less molybdenum, 10.0 to 43.0 wt %, for example 23.0 to 27.0 wt % platinum and the balance nickel. The total combined amount of tantalum and tungsten in these metallic coatings is in the range of 3.0 to 12 wt % and for example in the range of 5.5 to 11.0 wt %.

Within this third family of coatings, a particularly useful coating composition consists of 8.0 wt % cobalt, 4.0 wt % chromium, 9.0 wt % aluminum, 5.0 wt % tantalum, 1.0 wt % molybdenum, 4.0 wt % tungsten, 0.6 wt % yttrium, 0.6 wt % hafnium, 0.2 wt % silicon, 0.1 wt % zirconium, and about 23.0 to about 27.0 wt % platinum.

FIG. 2 charts the weight gain per surface area of the first family of coatings 2 and the third family of coatings 4 as they compare to the Re-containing coating of U.S. Pat. No. 6,919,042 and the U.S. Pat. No. 6,919,042 Re-containing coating with platinum 3. The oxide growth is measured by weight gain per surface area (Δm/Aₛ (mg/cm²)) 10 on the y-axis versus the number of 60 minute cycles 20 on the x-axis. The 60 minute cycles are hot/cold cycles consisting of 52 minutes at a temperature of about 2085° F. to 2115° F. and 8 minutes cooling to a temperature of approximately 212° F. The oxide growth kinetics are measured as a function of time. Slower weight gain results in better oxide growth, i.e. oxidation kinetics.

U.S. Pat. No. 6,919,042 Re containing coating 1, FIG. 2 displays parabolic mass gain/surface area for the initial stages of oxidation; however, following additional exposure, e.g., greater than nominally 350 cycles at 2100° F. Region 1 a, the oxidation behavior of the composition experiences a large mass gain. Compared with coating 2, a non-Re containing embodiment from the first family of coatings, the mass gain/surface area with time is much more uniform with little deviation from its parabolic features. Further, at exposures greater than 400 cycles Region 2 a, the predominately parallel curves of coating 1 and coating 2 shows that the oxidation rates are similar; however, the mass gain of coating 2 appears kinetically more favorable than coating 1.

In FIG. 2, the Pt-containing embodiments of the present invention, 3 and 4, exhibit slower oxidation kinetics than their non-Pt containing counterparts, and thus, appear more favorable from a long term oxidation resistance point of view. The Re-containing coating according to U.S. Pat. No. 6,919,042, with platinum 3, shows an initial mass loss. The initial mass loss is suspected to be due to the Pt plating process, e.g. some of the Pt was not fully adhered. As compared to coating with platinum 4, Re-containing coating 3 gains weight at a faster rate. While the oxidation behavior at the onset of testing is not straightforward, it was observed that the overall oxidation rate is quite favorable.

A driver of poor coating fatigue performance is excessive coating thickness. Coatings with the aforesaid compositions may have a thickness of 1 to 10 mils (0.001 to 0.01 inch), for example 1 to 2 mils (0.001 to 0.002 inch). Typical methods of depositing overlay coatings include thermal spray techniques such as low pressure plasma spray (LPPS), which creates coating thicknesses in the range of 4 to 12 mils (0.004 to 0.012 inch). Using cathodic arc plasma vapor deposition techniques, it is possible to apply coatings with the aforesaid compositions having a thickness of 2 mils (0.002 inch) or thinner. Techniques for applying the coatings of the present disclosure by cathodic arc plasma vapor deposition are discussed in U.S. Pat. Nos. 5,972,185; 5,932,078; 6,036,828; 5,792,267; and 6,224,726, all of which are incorporated by reference herein. Alternate methods of deposition, including other plasma vapor deposition techniques such as magnetron sputtering and electron beam plasma vapor deposition may be used. When thickness concerns are not present, various thermal spray techniques such as low pressure plasma spray and HVOF (high velocity oxy-fuel) techniques may be utilized.

For example, the third family of coatings containing Pt may be deposited by various coating methods, such as the coating methods detailed above, various coating methods within the art and/or additional methods. For instance, it is possible to deposit the Pt after the non-Pt portion of the coating is deposited via a cathodic arc plasma technique or a LPPS technique. In this coating example, the Pt is deposited over the top of the pre-deposited coating via plating, EB-PVD, sputtering or some other physical vapor deposition (PVD) method. The Pt is then diffused into the coating. The Pt may also be deposited prior to the non-Pt PVD coating process. In this instance, the bond coat is deposited on top of the Pt interlayer and then subjected to a diffusion heat treatment. Alternatively, Pt may be incorporated into the coating source material and deposited via conventional aforementioned PVD methods.

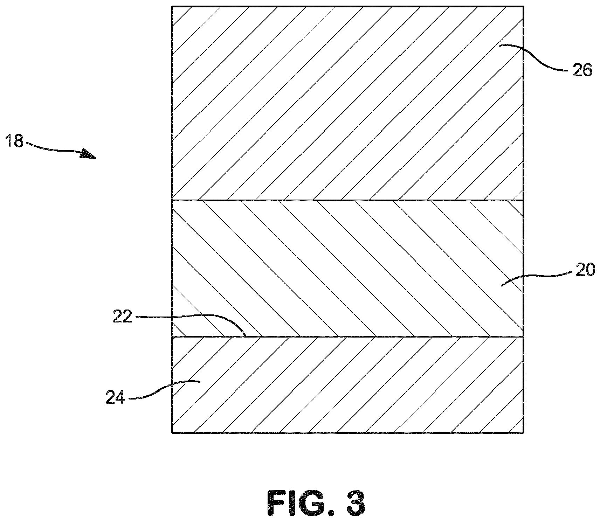

Referring now to FIG. 3, a coating system 18 includes a bond coat 20 applied to a surface 22 of a substrate 24, such as a turbine engine component including, but not limited to, a blade or a vane 12 as described above. The bond coat 20 comprises the low-cost metallic coatings described above. The coatings can be used as the bond coat used within a coating system 18. A thermal barrier coating (TBC) 26 is coupled to the bond coat 20. The thermal barrier coating 26 comprises metallic coatings that have a composition of yttria-stabilized zirconia.

The substrate 24 may be formed from any suitable material such as a nickel based superalloy, a cobalt based alloy, a molybdenum based alloy or a titanium alloy. The substrate 24 is coated with a metallic bondcoat 20 (as described above). Metallic bondcoats 20 which are used are described above. The bondcoat 20 may have any desired thickness.

The TBC 26 can consist of a single layer, two layer, or three layer ceramic coating.

These layers can be yttria- stabilized zirconia (YSZ), rare earth zirconates, or combinations of the two.

The yttria-stabilized zirconia thermal barrier coating 26 may be applied by, for example, electron beam physical vapor deposition (EB-PVD) or air plasma spray. Other methods which can be used to deposit the yttria stabilized zirconia thermal barrier coating 26 includes, but is not limited to, sol-gel techniques, slurry techniques, sputtering techniques, and chemical vapor deposition techniques.

The method of application may also include a variation of the EBPVD process which allows TBC to be deposited in hidden areas of the vane doublet (the "Non-Line-of-Site" process).

A preferred process for performing the deposition of the yttria-stabilized zirconia thermal barrier coating 26 is EB-PVD. When performing this process, the substrate 24 is placed in a coating chamber and heated to a temperature in the range of from 1700 to 2000 degrees Fahrenheit. The coating chamber is maintained at a pressure in the range of from 0.1 to 1.0 millitorr. The feedstock feed rate is from 0.2 to 1.5 inches/hour. The coating time may be in the range of from 20 to 120 minutes.

The deposited coating 26 may have a thickness of from 3.0 to 50 mils, preferably from 5.0 to 15 mils. The deposited coating 26 may have a yttria content in the range of from 4.0 to 25 wt %, preferably from 6.0 to 9.0 wt %. The deposited coating 26 may consist of yttria in the amount of 4.0 to 25 wt % and the balance zirconia. In a more preferred embodiment, the deposited coating 26 may consist of yttria in the amount of 6.0 to 9.0 wt % yttria and the balance zirconia.

The disclosed materials system is capable of providing cooled turbine hardware with extended TBC spallation life. This will be beneficial for any hot section component in legacy and next generation engines that relies on a thermal barrier coating.

TBC spallation resistance superior to legacy MCrAlY-type bond coat/ EBPVD systems is achieved by combining a single crystal Ni-base superalloy material with the disclosed advanced bond coat and the EBPVD thermal barrier coating.

The use of the disclosed advanced bond coat has a gamma/gamma prime structure, in contrast to traditional gamma/beta coatings, and provides a significant increase in ceramic spallation life. More modest, yet significant, increases in bond coat oxidation life have also been measured in laboratory testing.

Increased TBC spallation and bond coat oxidation life allow for extended time on wing in aggressive environments. The result is an increase in HSRI and reduced maintenance cost relative to legacy materials systems, as described above.

Combining all three of the described technologies; nozzle segment, bond coat, and thermal barrier coating, results in a materials system that can be used in the hot section of a gas turbine engine, resulting in a substantial life extension.

It is apparent that there has been provided in accordance with the present disclosure a cooled component with a coating system having a thermal barrier coating and a low-cost oxidation and fatigue resistant metallic coating which fully satisfies the embodiments set forth hereinbefore. While the present disclosure has been described in the context of specific coatings thereof, other alternatives, modifications, and variations will become apparent to those skilled in the art having read the foregoing description. Accordingly, it is intended to embrace those alternatives, modifications, and variations as they fall within the broad scope of the appended claims.

## Claims

1. A method for providing a component with a coating system comprising the steps of:
providing an air cooled component having a substrate;
applying a metallic bondcoat to said substrate; and
depositing a layer of an yttria-stabilized zirconia thermal barrier coating on the bondcoat,
wherein said air cooled component comprises a nozzle segment selected from the group consisting of a singlet, a doublet and a triplet,
wherein said metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 0.0 to 9.0 wt % tungsten, 0.0 to 10 wt % molybdenum, 0.0 to 43.0 wt % platinum, and the balance nickel.

2. The method according to claim 1 wherein said bondcoat and/or thermal barrier coating is applied using plasma vapour deposition or thermal spray techniques.

3. The method according to claim 1 or claim 2, wherein said metallic bondcoat applying step comprises applying a metallic bondcoat selected from the group consisting of a platinum-aluminide coating and an aluminide coating.

4. The method according to any preceding claim, wherein said metallic bondcoat applying step comprises applying a metallic bondcoat wherein said metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 2.5-5.0 wt % tungsten, 0.0 to 10 wt % molybdenum, 23.0 to 27.0 wt % platinum, and the balance nickel.

5. The method according to any preceding claim, wherein said yttria-stabilized zirconia coating depositing step comprises depositing a material containing from 4.0 to 25 wt % yttria.

6. The method according to claim 5, wherein the balance is zirconia.

7. The method according to any preceding claim, wherein said air cooled component providing step comprises providing a substrate formed from a nickel based alloy.

8. The method of any preceding claim, further comprising:
installing said air cooled component in a high pressure turbine section of a gas turbine engine.

9. A gas turbine engine component comprising:
a nozzle segment, said nozzle segment comprising at least one substrate having a surface;
a metallic bondcoat coupled to said surface of said substrate; and
an yttria-stabilized zirconia thermal barrier coating coupled to said metallic bondcoat opposite said surface,
wherein said nozzle segment is selected from the group consisting of a singlet, a doublet and a triplet,
wherein said metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 0.0 to 9.0 wt % tungsten, 0.0 to 10 wt % molybdenum, 0.0 to 43.0 wt % platinum, and the balance nickel.

10. The gas turbine engine component according to claim 9 wherein said metallic bondcoat is selected from the group consisting of a platinum-aluminide coating and an aluminide coating.

11. The gas turbine engine component according to claim 9 or claim 10 wherein said metallic bondcoat has a composition consisting of 1.0 to 18 wt % cobalt, 3.0 to 18 wt % chromium, 5.0 to 15 wt % aluminum, 0.01 to 1.0 wt % yttrium, 0.01 to 0.6 wt % hafnium, 0.0 to 0.3 wt % silicon, 0.1 to 1.0 wt % zirconium, 0.0 to 10 wt % tantalum, 2.5-5.0 wt % tungsten, 0.0 to 10 wt % molybdenum, 23.0 to 27.0 wt % platinum, and the balance nickel.

12. The gas turbine engine component according to any one of claims 9-11 wherein said yttria-stabilized zirconia coating comprises a material containing from 4.0 to 25 wt % yttria.

13. The gas turbine engine component according to claim 12 wherein the balance is zirconia.

14. The gas turbine engine component according to any one of claims 9-13 wherein said nozzle segment is configured air cooled.

## Patentansprüche

1. Verfahren zum Bereitstellen eines Bauteils mit einem Beschichtungssystem, umfassend die folgenden Schritte:
Bereitstellen eines luftgekühlten Bauteils, das ein Substrat aufweist;
Aufbringen einer metallischen Bindungsbeschichtung auf das Substrat; und
Abscheiden einer Schicht einer Yttriumoxid-stabilisierten Zirconiumoxid-Wärmedämmbeschichtung auf der Bindungsbeschichtung,
wobei das luftgekühlte Bauteil ein Düsensegment umfasst, das ausgewählt ist aus der Gruppe bestehend aus einem Singulett, einem Dublett und einem Triplett,
wobei die metallische Bindungsbeschichtung eine Zusammensetzung aufweist, die aus 1,0 bis 18 Gew.-% Cobalt, 3,0 bis 18 Gew.-% Chrom, 5,0 bis 15 Gew.-% Aluminium, 0,01 bis 1,0 Gew.-% Yttrium, 0,01 bis 0,6 Gew.-% Hafnium, 0,0 bis 0,3 Gew.-% Silicium, 0,1 bis 1,0 Gew.-% Zirconium, 0,0 bis 10 Gew.-% Tantal, 0,0 bis 9,0 Gew.-% Wolfram, 0,0 bis 10 Gew.-% Molybdän, 0,0 bis 43,0 Gew.-% Platin und Nickel als Rest besteht.

2. Verfahren nach Anspruch 1, wobei die Bindungsbeschichtung und/oder die Wärmedämmbeschichtung unter Verwendung von Plasmadampfabscheidung oder thermischen Sprühtechniken aufgebracht wird.

3. Verfahren nach Anspruch 1 oder Anspruch 2, wobei der Schritt des Aufbringens der metallischen Bindungsbeschichtung das Aufbringen einer metallischen Bindungsbeschichtung umfasst, die ausgewählt ist aus der Gruppe bestehend aus einer Platinaluminidbeschichtung und einer Aluminidbeschichtung.

4. Verfahren nach einem der vorhergehenden Ansprüche, wobei der Schritt des Aufbringens der metallischen Bindungsbeschichtung das Aufbringen der metallischen Bindungsbeschichtung umfasst, wobei die metallische Bindungsbeschichtung eine Zusammensetzung aufweist, die aus 1,0 bis 18 Gew.-% Cobalt, 3,0 bis 18 Gew.-% Chrom, 5,0 bis 15 Gew.-% Aluminium, 0,01 bis 1,0 Gew.-% Yttrium, 0,01 bis 0,6 Gew.-% Hafnium, 0,0 bis 0,3 Gew.-% Silicium, 0,1 bis 1,0 Gew.-% Zirconium, 0,0 bis 10 Gew.-% Tantal, 2,5 bis 5,0 Gew.-% Wolfram, 0,0 bis 10 Gew.-% Molybdän, 23,0 bis 27,0 Gew.-% Platin und Nickel als Rest besteht.

5. Verfahren nach einem der vorhergehenden Ansprüche, wobei der Schritt des Abscheidens der Yttriumoxid-stabilisierten Zirconiumoxid-Beschichtung das Abscheiden eines Materials umfasst, das von 4,0 bis 25 Gew.-% Yttriumoxid enthält.

6. Verfahren nach Anspruch 5, wobei der Rest Zirconiumoxid ist.

7. Verfahren nach einem der vorhergehenden Ansprüche, wobei der Schritt des Bereitstellens des luftgekühlten Bauteils das Bereitstellen eines aus einer Legierung auf Nickelbasis gebildeten Substrats umfasst.

8. Verfahren nach einem der vorhergehenden Ansprüche, ferner umfassend:
Installieren des luftgekühlten Bauteils in einem Hochdruckturbinenabschnitt eines Gasturbinenmotors.

9. Bauteil für einen Gasturbinenmotor, umfassend:
ein Düsensegment, wobei das Düsensegment mindestens ein Substrat mit einer Fläche aufweist;
eine metallische Bindungsbeschichtung, die an die Fläche des Substrats gekoppelt ist; und
eine Yttriumoxid-stabilisierte Zirconiumoxid-Wärmedämmbeschichtung, die an die metallische Bindungsbeschichtung gegenüber der Fläche gekoppelt ist,
wobei das Düsensegment ausgewählt ist aus der Gruppe bestehend aus einem Singulett, einem Dublett und einem Triplett,
wobei die metallische Bindungsbeschichtung eine Zusammensetzung aufweist, die aus 1,0 bis 18 Gew.-% Cobalt, 3,0 bis 18 Gew.-% Chrom, 5,0 bis 15 Gew.-% Aluminium, 0,01 bis 1,0 Gew.-% Yttrium, 0,01 bis 0,6 Gew.-% Hafnium, 0,0 bis 0,3 Gew.-% Silicium, 0,1 bis 1,0 Gew.-% Zirconium, 0,0 bis 10 Gew.-% Tantal, 0,0 bis 9,0 Gew.-% Wolfram, 0,0 bis 10 Gew.-% Molybdän, 0,0 bis 43,0 Gew.-% Platin und Nickel als Rest besteht.

10. Bauteil für einen Gasturbinenmotor nach Anspruch 9, wobei die metallische Bindungsbeschichtung ausgewählt ist aus der Gruppe bestehend aus einer Platinaluminidbeschichtung und einer Aluminidbeschichtung.

11. Bauteil für einen Gasturbinenmotor nach Anspruch 9 oder Anspruch 10, wobei die metallische Bindungsbeschichtung eine Zusammensetzung aufweist, die aus 1,0 bis 18 Gew.-% Cobalt, 3,0 bis 18 Gew.-% Chrom, 5,0 bis 15 Gew.-% Aluminium, 0,01 bis 1,0 Gew.-% Yttrium, 0,01 bis 0,6 Gew.-% Hafnium, 0,0 bis 0,3 Gew.-% Silicium, 0,1 bis 1,0 Gew.-% Zirconium, 0,0 bis 10 Gew.-% Tantal, 2,5 bis 5,0 Gew.-% Wolfram, 0,0 bis 10 Gew.-% Molybdän, 23,0 bis 27,0 Gew.-% Platin und Nickel als den Rest besteht.

12. Bauteil für einen Gasturbinenmotor nach einem der Ansprüche 9-11, wobei die Yttriumoxid-stabilisierte Zirconiumoxid-Beschichtung ein Material umfasst, das von 4,0 bis 25 Gew.-% Yttriumoxid enthält.

13. Bauteil für einen Gasturbinenmotor nach Anspruch 12, wobei der Rest Zirconiumoxid ist.

14. Bauteil für einen Gasturbinenmotor nach einem der Ansprüche 9-13, wobei das Düsensegment luftgekühlt konfiguriert ist.

## Revendications

1. Procédé de fourniture d'un composant avec un système de revêtement comprenant les étapes :
de fourniture d'un composant refroidi par air ayant un substrat ;
d'application d'une couche de liaison métallique sur ledit substrat ; et
de dépôt d'une couche d'un revêtement de barrière thermique en zircone stabilisée à l'yttria sur la couche de liaison,
dans lequel ledit composant refroidi par air comprend un segment de buse choisi dans le groupe constitué d'un singulet, d'un doublet et d'un triplet,
dans lequel ladite couche de liaison métallique a une composition constituée de 1,0 à 18 % en poids de cobalt, 3,0 à 18 % en poids de chrome, 5,0 à 15 % en poids d'aluminium, 0,01 à 1,0 % en poids d'yttrium, 0,01 à 0,6 % en poids d'hafnium, 0,0 à 0,3 % en poids de silicium , 0,1 à 1,0 % en poids de zirconium, 0,0 à 10 % en poids de tantale, 0,0 à 9,0 % en poids de tungstène, 0,0 à 10 % en poids de molybdène, 0,0 à 43,0 % en poids de platine et le reste en nickel.

2. Procédé selon la revendication 1 dans lequel ladite couche de liaison et/ou ledit revêtement de barrière thermique est appliqué(e) à l'aide de techniques de dépôt plasma en phase vapeur ou de projection thermique.

3. Procédé selon la revendication 1 ou la revendication 2, dans lequel ladite étape d'application d'une couche de liaison métallique comprend l'application d'une couche de liaison métallique choisie dans le groupe constitué d'un revêtement d'aluminure de platine et d'un revêtement d'aluminure.

4. Procédé selon une quelconque revendication précédente, dans lequel ladite étape d'application de la couche de liaison métallique comprend l'application d'une couche de liaison métallique dans lequel ladite couche de liaison métallique a une composition constituée de 1,0 à 18 % en poids de cobalt, 3,0 à 18 % en poids de chrome, 5,0 à 15 % en poids d'aluminium, 0,01 à 1,0 % en poids d'yttrium, 0,01 à 0,6 % en poids d'hafnium, 0,0 à 0,3 % en poids de silicium, 0,1 à 1,0 % en poids de zirconium, 0,0 à 10 % en poids de tantale, 2,5-5,0 % en poids de tungstène, 0,0 à 10 % en poids de molybdène, 23,0 à 27,0 % en poids de platine et le reste en nickel.

5. Procédé selon une quelconque revendication précédente, dans lequel ladite étape de dépôt de revêtement de zircone stabilisée à l'yttria comprend le dépôt d'un matériau contenant de 4,0 à 25 % en poids d'yttria.

6. Procédé selon la revendication 5, dans lequel le reste est en zircone.

7. Procédé selon une quelconque revendication précédente, dans lequel ladite étape de fourniture de composant refroidi par air comprend la fourniture d'un substrat formé à partir d'un alliage à base de nickel.

8. Procédé selon une quelconque revendication précédente, comprenant en outre :
l'installation dudit composant refroidi par air dans une section de turbine à haute pression d'un moteur à turbine à gaz.

9. Composant de moteur à turbine à gaz comprenant :
un segment de buse, ledit segment de buse comprenant au moins un substrat ayant une surface ;
une couche de liaison métallique couplée à ladite surface dudit substrat ; et
un revêtement de barrière thermique en zircone stabilisé à l'yttria couplé à ladite couche de liaison métallique opposée à ladite surface,
dans lequel ledit segment de buse est choisi dans le groupe constitué d'un singulet, d'un doublet et d'un triplet,
dans lequel ladite couche de liaison métallique a une composition constituée de 1,0 à 18 % en poids de cobalt, 3,0 à 18 % en poids de chrome, 5,0 à 15 % en poids d'aluminium, 0,01 à 1,0 % en poids d'yttrium, 0,01 à 0,6 % en poids d'hafnium, 0,0 à 0,3 % en poids de silicium , 0,1 à 1,0 % en poids de zirconium, 0,0 à 10 % en poids de tantale, 0,0 à 9,0 % en poids de tungstène, 0,0 à 10 % en poids de molybdène, 0,0 à 43,0 % en poids de platine et le reste en nickel.

10. Composant de moteur à turbine à gaz selon la revendication 9, dans lequel ladite couche de liaison métallique est choisie dans le groupe constitué d'un revêtement d'aluminure de platine et d'un revêtement d'aluminure.

11. Composant de moteur à turbine à gaz selon la revendication 9 ou la revendication 10, dans lequel ladite couche de liaison métallique a une composition constituée de 1,0 à 18 % en poids de cobalt, 3,0 à 18 % en poids de chrome, 5,0 à 15 % en poids d'aluminium, 0,01 à 1,0 % en poids d'yttrium, 0,01 à 0,6 % en poids d'hafnium, 0,0 à 0,3 % en poids de silicium, 0,1 à 1,0 % en poids de zirconium, 0,0 à 10 % en poids de tantale, 2,5 à 5,0 % en poids de tungstène, 0,0 à 10 % en poids de molybdène, 23,0 à 27,0 % en poids de platine et le reste nickel.

12. Composant de moteur à turbine à gaz selon l'une quelconque des revendications 9 à 11, dans lequel ledit revêtement de zircone stabilisé à l'yttria comprend un matériau contenant de 4,0 à 25 % en poids d'yttria.

13. Composant de moteur à turbine à gaz selon la revendication 12, dans lequel le reste est en zircone.

14. Composant de moteur à turbine à gaz selon l'une quelconque des revendications 9 à 13, dans lequel ledit segment de buse est configuré refroidi par air.
